# EUROPÄISCHE PATENTSCHRIFT

(11) **EP 4 264 287 B1**
(45) Veröffentlichungstag und Bekanntmachung des Hinweises auf die Patenterteilung: **11.03.2026**
(21) Anmeldenummer: 21809955.4
(22) Anmeldetag: 08.11.2021
(51) Int. Cl.: G01R 1/067, G01R 31/66

(54) **EINZELKONTAKTIERUNGSEINRICHTUNG FÜR EINE PRÜFVORRICHTUNG ZUM DURCHGANGSPRÜFEN EINES STECKVERBINDERS UND PRÜFVORRICHTUNG**
INDIVIDUALLY CONTACTING APPARATUS FOR A TESTING DEVICE FOR CONTINUITY TESTING OF A PLUG CONNECTOR AND TESTING DEVICE
APPAREIL DE MISE EN CONTACT INDIVIDUEL DESTINE A UN DISPOSITIF DE TEST POUR LE CONTROLE DE CONTINUITE D'UN CONNECTEUR ENFICHABLE, ET DISPOSITIF DE TEST

(30) Priorität: 16.12.2020 DE 102020133736
(43) Veröffentlichungstag der Anmeldung: 25.10.2023
(73) Patentinhaber: Lisa Dräxlmaier GmbH, 84137 Vilsbiburg (DE)
(72) Erfinder: REITER, Magdalena, 84155 Bodenkirchen (DE); KAGERHUBER, Manuel, 84140 Gangkofen (DE)
(86) Internationale Anmeldenummer: PCT/EP2021/080857
(87) Internationale Veröffentlichungsnummer: WO 2022/128253

(56) Entgegenhaltungen:
- WO-A1-2020/110960
- DE-B3- 102006 025 850
- DE-B3- 102019 108 831

## Beschreibung

### Technisches Gebiet

Die vorliegende Erfindung betrifft eine Einzelkontaktierungseinrichtung für eine Prüfvorrichtung zum Durchgangsprüfen eines Steckverbinders und eine Prüfvorrichtung mit zumindest einer solchen Einzelkontaktierungseinrichtung.

### Stand der Technik

Die vorliegende Erfindung wird im Folgenden hauptsächlich in Verbindung mit Steckverbindern für Fahrzeugbordnetze beschrieben. Die Erfindung kann aber für jede Anwendung genutzt werden, in der Steckverbinder elektrisch überprüft werden sollen.

Ein Steckverbinder kann zwei im Wesentlichen gegengleiche Komponenten aufweisen. Die eine Komponente kann zumindest ein männliches Kontaktelement aufweisen. Die andere Komponente kann zumindest ein weibliches Kontaktelement aufweisen. Die Komponenten können jeweils eine Vielzahl von Kontaktelementen aufweisen. Insbesondere die weiblichen Kontaktelemente können innerhalb eines Gehäuses der Komponente angeordnet sein. Einem Kontaktelement kann eine Aussparung des Gehäuses zugeordnet sein. Die Kontaktelemente können sehr geringe laterale Abstände zueinander aufweisen. Somit können die Aussparungen im Gehäuse ebenfalls ein enges Raster aufweisen.

Die Kontaktelemente können Lamellenkontakte sein. Dabei weist ein weibliches Kontaktelement ein Lamellenpaar aus zwei eng beieinander liegenden Lamellen auf. Das männliche Kontaktelement weist eine einzelne Lamelle auf, die zum Herstellen einer elektrisch leitenden Verbindung zwischen das Lamellenpaar des weiblichen Kontaktelements gesteckt wird. Insbesondere bei Steckverbindern mit Lamellenkontakten kann die Anforderung bestehen, eine eindringfreie elektrische Prüfung durchzuführen, um einer Verformung der Lamellenkontakte aufgrund der Prüfung auszuschließen.

Dazu kann pro Kontaktelement eine Einzelkontaktierungseinrichtung mit einem Kontaktstift verwendet werden. Der Kontaktstift kann in die Aussparung des Gehäuses eingeführt werden und innerhalb des Gehäuses mit einer definierten Kraft gegen eine Oberkante der Lamellen gepresst werden, um einen elektrisch leitenden Kontakt zu den Lamellen herzustellen.

Der Kontaktstift bzw. die Einzelkontaktierungseinrichtung kann Teil einer Prüfvorrichtung sein. Zum Prüfen von Steckverbindern mit vielen Kontaktelementen kann die Prüfvorrichtung sehr viele exakt ausgerichtete Kontaktstifte aufweisen. Wenn nur ein einzelner der Kontaktstifte nicht in seine vorgesehene Aussparung des Gehäuses eingeführt werden kann, kann der Steckverbinder nicht vollständig überprüft werden.

DE 10 2006 025850 B3 zeigt einen Prüfstift für eine Prüfvorrichtung zum Prüfen von Steckern, eine Prüfvorrichtung unter Verwendung eines Prüfstiftes sowie ein Verfahren zum Prüfen von Steckern.

WO 2020/110960 A1 zeigt eine Sondenanschlussstruktur und eine Sonde zur Konnektierung der Sonde mit einer Anschlusselektrode eines mehrpoligen Steckverbinders, um eine Schaltungseigenschaft eines mit dem mehrpoligen Steckverbinder versehenen elektronischen Geräts zu prüfen.

DE 10 2019 108831 B3 zeigt einen Kontaktstift und einen Prüfadapter zum Überprüfen eines elektrischen Steckverbinders.

### Beschreibung der Erfindung

Eine Aufgabe der Erfindung ist es daher, unter Einsatz konstruktiv möglichst einfacher Mittel eine verbesserte Einzelkontaktierungseinrichtung und eine verbesserte Prüfvorrichtung bereitzustellen.

Die Aufgabe wird durch die Gegenstände der unabhängigen Ansprüche gelöst. Vorteilhafte Weiterbildungen der Erfindung sind in den abhängigen Ansprüchen, der Beschreibung und den begleitenden Figuren angegeben. Insbesondere können die unabhängigen Ansprüche einer Anspruchskategorie auch analog zu den abhängigen Ansprüchen einer anderen Anspruchskategorie weitergebildet sein.

Durch den hier vorgestellten Ansatz kann sichergestellt werden, dass ein Kontaktstift automatisch an einer Aussparung eines Gehäuses eines Steckverbinders ausgerichtet wird, bevor der Kontaktstift in die Aussparung eintaucht, um ein Kontaktelement des Steckverbinders zu kontaktieren. Das Kontaktelement kann auch eindringungsfrei kontaktiert werden.

Es wird eine Einzelkontaktierungseinrichtung für eine Prüfvorrichtung zum Durchgangsprüfen eines Steckverbinders vorgeschlagen, wobei die Einzelkontaktierungseinrichtung einen Kontaktstift zum Aufsetzen auf ein zu kontaktierendes Kontaktelement des Steckverbinders und eine vorauseilende Zentrierhilfe für den Kontaktstift aufweist, wobei der Kontaktstift elektrisch leitend und in einer Aufsetzrichtung federgelagert ist und die Zentrierhilfe koaxial zum Kontaktstift beweglich federgelagert ist. Die Einzelkontaktierungseinrichtung ist hierbei vorzugsweise derart ausgestaltet, dass die Zentrierhilfe bei einem Kontaktierungsvorgang zuerst auf einem Gehäuse des Steckverbinders aufsetzt, an dem Gehäuse zentriert und dabei den Kontaktstift an einer Aussparung des Gehäuses ausrichtet, wobei die Zentrierhilfe im weiteren Verlauf des Kontaktierungsvorgangs koaxial zum Kontaktstift einfedert, bis der Kontaktstift an dem zu kontaktierenden Kontaktelement anliegt.

Weiterhin wird eine Prüfvorrichtung zum elektrischen Prüfen eines Steckverbinders vorgestellt, wobei die Prüfvorrichtung zumindest eine Einzelkontaktierungseinrichtung, vorzugsweise eine Mehrzahl von nebeneinander angeordneten Einzelkontaktierungseinrichtungen gemäß dem hier vorgestellten Ansatz aufweist.

Eine Einzelkontaktierungseinrichtung ist dazu ausgebildet, ein einzelnes elektrisch leitendes Kontaktelement eines Steckverbinders elektrisch zu kontaktieren. Dabei kann insbesondere ein innerhalb eines Gehäuses des Steckverbinders angeordnetes Kontaktelement kontaktiert werden. Das Kontaktelement kann dabei ein männliches Kontaktelement oder ein weibliches Kontaktelement sein. Zum Kontaktieren kann ein Kontaktstift der Einzelkontaktierungseinrichtung in eine Aussparung des Gehäuses eingeführt werden, bis der Kontaktstift an dem Kontaktelement anliegt. Eine Richtung, aus der der Kontaktstift in das Gehäuse eingeführt wird, kann als Aufsetzrichtung bezeichnet werden. Die Aufsetzrichtung kann einer Steckrichtung des Kontaktelements entsprechen. Der Kontaktstift kann dabei so ausgerichtet sein, dass er nicht in das Kontaktelement eindringen kann. Der Kontaktstift kann dann eindringungsfrei am Kontaktelement anliegen. Insbesondere kann der Kontaktstift quer zu dem Kontaktelement ausgerichtet sein. Alternativ dazu kann der Kontaktstift auch in das Kontaktelement eindringen, um den elektrisch leitenden Kontakt herzustellen. Der Kontaktstift kann so stark gegen das Kontaktelement gedrückt werden, bis der Kontaktstift mit einer definierten Anlagekraft am Kontaktelement anliegt. Beim Andrücken kann der Kontaktstift einfedern.

Eine Zentrierhilfe kann in einer ausgefederten Position entgegen der Aufsetzrichtung über den Kontaktstift hinausragen. Die Zentrierhilfe und der Kontaktstift können in axialer Richtung relativ zueinander verlagert werden. In einer eingefederten Position der Zentrierhilfe kann der Kontaktstift entgegen der Aufsetzrichtung über die Zentrierhilfe hinausragen. Die Zentrierhilfe kann elektrisch isolierend sein. Insbesondere kann die Zentrierhilfe aus einem Kunststoffmaterial, beispielsweise einem Polymer, bestehen. Die Zentrierhilfe kann alternativ auch aus einem Metallmaterial bestehen. Die Zentrierhilfe kann eine Außenseite des Gehäuses abtasten und sich an einer Kontur des Gehäuses zentrieren, bevor der Kontaktstift das Gehäuse berührt. Falls die Zentrierhilfe einen Seitenversatz und/oder einen Winkelversatz zu der Kontur aufweisen sollte, wirken beim Aufsetzen der Zentrierhilfe auf das Gehäuse Seitenkräfte quer zur Zentrierhilfe. Die Seitenkräfte bewegen und/oder drehen die Zentrierhilfe soweit, bis sie auf die Kontur zentriert ist. Die Zentrierhilfe nimmt den Kontaktstift bei der seitlichen Bewegung und/oder Drehung mit und richtet ihn damit an der Kontur aus. Anders ausgedrückt ist die Zentrierhilfe derart relativ zu dem Kontaktstift gehalten und geführt, dass sie sich in axialer Richtung relativ zu dem Kontaktstift federnd verlagern lässt, aber in lateraler Richtung relativ zu dem Kontaktstift fest gehalten ist. In der ausgerichteten Position ist der Kontaktstift exakt vor der Aussparung angeordnet und kann somit, insbesondere ohne einen Rand der Aussparung zu berühren, in die Aussparung eingeführt werden.

Der Kontaktstift kann nach dem Aufsetzen auf das Kontaktelement um eine vorbestimmte Strecke einfedern, um einen vorgegebenen Anpressdruck zu erreichen. Durch das Einfedern werden Toleranzen des Kontaktelements ausgeglichen, sodass alle Kontaktelemente des Steckverbinders sicher elektrisch kontaktiert werden.

Das vorauseilende Ende der Zentrierhilfe kann eine Zentrierschräge aufweisen. Das vorauseilende Ende kann angespitzt sein. Eine Spitze des vorauseilenden Endes kann durch die Zentrierschräge geringere Abmessungen aufweisen als die Aussparung des Gehäuses. Durch die Zentrierschräge kann sich das vorauseilende Ende auch in einer Aussparung ohne Einführschräge zentrieren.

Die Zentrierhilfe kann an einem vorauseilenden Ende eine Zentrierkontur aufweisen. Die Zentrierkontur kann eine Steckkontur des Gehäuses zumindest anteilig negativ abbilden. Eine Steckkontur kann ein Eindringen des anderen Kontaktelements in das Gehäuse erleichtern. Die Steckkontur kann Einführschrägen aufweisen. Die Einführschrägen können trichterförmig sein. Bei Lamellenkontakten kann die Steckkontur insbesondere als parallel zu den Lamellen ausgerichteter Schlitz mit Einführschrägen ausgeprägt sein. Eine Negativform der Steckkontur kann ähnliche Schrägen und Proportionen aufweisen, wie die Steckkontur, dabei jedoch als Vorsprung ausgebildet sein.

Die Einzelkontaktierungseinrichtung kann eine koaxial zum Kontaktstift und/oder der Zentrierhilfe angeordnete Hülse aufweisen. Eine die Zentrierhilfe abstützende Feder kann innerhalb der Hülse angeordnet sein. Eine Hülse kann ein Abschnitt eines Rohrs sein. Die Hülse kann einen runden Querschnitt aufweisen. Die Hülse kann die Feder seitlich abstützen und ein seitliches Ausweichen der Feder beim Einfedern verhindern. Die Hülse kann auch als Führungselement für die Zentrierhilfe dienen.

Der Kontaktstift weisteinen abgeflachten Kopfbereich auf. Die Zentrierhilfe weist einen seitlich zum Kopfbereich versetzten Zentrierbereich auf. Der Zentrierbereich liegt an dem Kopfbereich an und bildet das vorauseilende Ende aus. Der Kopfbereich kann eine Querschnittsfläche aufweisen, die ähnlich geformt ist, wie eine Querschnittsfläche der Aussparung des Gehäuses. Der Zentrierbereich kann an eine Kontur des Gehäuses neben der Aussparung angepasst sein.

Die Zentrierhilfe kann in einer ausgefederten Position an einer Anschlagfläche des Kopfbereichs anliegen. Die Anschlagfläche kann quer zu der Aufsetzrichtung ausgerichtet sein. Die Anschlagfläche kann eine Strecke definieren, um die die Zentrierhilfe dem Kontaktstift vorauseilt. Der Kopfbereich kann zumindest an einer Seite über einen Schaft des Kontaktstifts überstehen. Der Überstand kann die Anschlagfläche ausbilden. Die Zentrierhilfe kann eine entsprechende Anschlagfläche aufweisen.

Der Kopfbereich ist zumindest anteilig in einer Nut des Zentrierbereichs angeordnet. Durch die Nut ist die Zentrierhilfe gegen ein Verdrehen am Kontaktstift gesichert. Die Nut führt den Kopfbereich zumindest in einer Richtung quer zur Nut. Durch die Nut kann der Zentrierbereich das Gehäuse an drei Seiten des Kontaktstifts abtasten. Beispielsweise kann der Zentrierbereich auf die Aussparung umgebende Einführschrägen des Gehäuses aufsetzen.

Der Kopfbereich und der Zentrierbereich können T-förmig zueinander ausgerichtet sein. Das Gehäuse kann eine eigene Prüfaussparung für den Kopfbereich aufweisen. Die Prüfaussparung kann quer zu der Aussparung für das eigentliche Kontaktelement ausgerichtet sein. Die Prüfaussparung kann ein Teil der Aussparung des Gehäuses sein. Dadurch kann der Kopfbereich quer auf das zu kontaktierende Kontaktelement aufgesetzt werden und kann dabei nicht in das Kontaktelement eindringen. Durch die T-Form kann sich der Zentrierbereich an der Aussparung für das Kontaktelement zentrieren und somit den Kopfbereich an der Prüfaussparung ausrichten. Die Prüfaussparung kann sich mit der Aussparung für das Kontaktelement überschneiden.

Die Zentrierhilfe kann einen hohlzylindrischen Schaft aufweisen. Der Kontaktstift kann einen zylindrischen Schaft aufweisen. Der zylindrische Schaft kann in dem hohlzylindrischen Schaft angeordnet sein. Der hohlzylindrische Schaft und der zylindrische Schaft können koaxial zueinander angeordnet sein. Der hohlzylindrische Schaft kann an dem zylindrischen Schaft in zwei Raumrichtungen geführt sein. Durch die koaxiale Anordnung ist die Zentrierhilfe sicher an dem Kontaktstift ausgerichtet.

### Kurze Figurenbeschreibung

Nachfolgend wird ein vorteilhaftes Ausführungsbeispiel der Erfindung unter Bezugnahme auf die begleitenden Figuren erläutert. Es zeigen:
Fig. 1 eine räumliche Darstellung einer Einzelkontaktierungseinrichtung gemäß einem Ausführungsbeispiel;
Fig. 2 eine räumliche Darstellung eines Steckverbinders mit einer Einzelkontaktierungseinrichtung gemäß einem Ausführungsbeispiel;
Fign. 3 und 4 Schnittansichten eines Steckverbinders mit einer Einzelkontaktierungseinrichtung gemäß einem Ausführungsbeispiel; und
Fig. 5 eine räumliche Darstellung einer Prüfvorrichtung gemäß einem Ausführungsbeispiel.

Die Figuren sind lediglich schematische Darstellungen und dienen nur der Erläuterung der Erfindung. Gleiche oder gleichwirkende Elemente sind durchgängig mit den gleichen Bezugszeichen versehen.

### Detaillierte Beschreibung

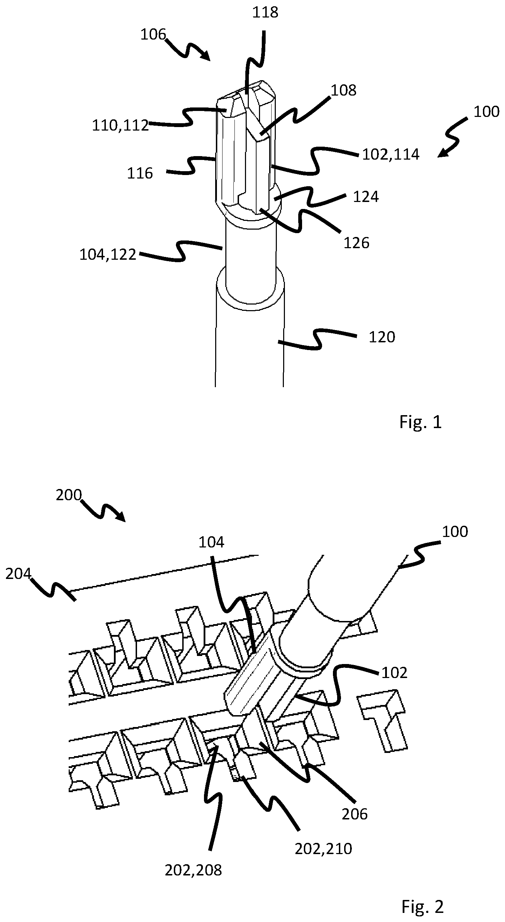

Fig. 1 zeigt eine räumliche Darstellung einer Einzelkontaktierungseinrichtung 100 gemäß einem Ausführungsbeispiel. Die Einzelkontaktierungseinrichtung 100 weist einen Kontaktstift 102 und eine Zentrierhilfe 104 auf. Der Kontaktstift 102 ist elektrisch leitend und dazu ausgebildet, für eine elektrische Prüfung auf einem einzelnen Kontaktelement eines Steckverbinders aufgesetzt zu werden. Der Kontaktstift 102 ist axial gefedert in einer Federbuchse gelagert. Somit kann der Kontaktstift 102 einfedern, wenn er auf das Kontaktelement aufgesetzt wird.

Die Zentrierhilfe 104 ist koaxial zum Kontaktstift 102 federnd gelagert und eilt dem Kontaktstift 102 voraus. Ein vorauseilendes Ende 106 der Zentrierhilfe 104 ragt in einem ausgefederten Zustand des Kontaktstifts 102 und der Zentrierhilfe 104 über eine Stirnfläche 108 des Kontaktstifts 102 hinaus.

Wenn die Einzelkontaktierungseinrichtung 100 für einen Prüfvorgang an den Steckverbinder mit dem vorauseilenden Ende 106 voran angenähert wird, setzt das vorauseilende Ende 106 beziehungsweise die Zentrierhilfe 104 zuerst auf einem Gehäuse des Steckverbinders auf. Die Zentrierhilfe 104 zentriert sich dabei an einer dafür vorgesehenen Kontur des Gehäuses. Der Kontaktstift 102 wird während des Zentrierens von der Zentrierhilfe 104 mitgenommen und an einer Aussparung des Gehäuses ausgerichtet. Wenn die Zentrierhilfe 104 ausgerichtet ist, federt die Zentrierhilfe 104 relativ zum Kontaktstift 102 ein, sodass der Kontaktstift 102 in dem so ausgerichteten Zustand an der Zentrierhilfe 104 vorbei in die Aussparung eintaucht und auf dem Kontaktelement aufsetzt. Wenn die Zentrierhilfe 104 eingefedert ist, ragt der Kontaktstift 102 über die Zentrierhilfe 104 hinaus.

In einem Ausführungsbeispiel weist das vorauseilende Ende 106 Zentrierschrägen 110 auf, die dazu ausgebildet ist, an einer Vertiefung oder einer Aussparung des Gehäuses zu zentrieren. Die Zentrierschrägen 110 bilden eine Spitze aus.

In einem Ausführungsbeispiel bilden die Zentrierschrägen 110 eine Zentrierkontur 112 aus. Die Zentrierkontur 112 ist dabei zumindest bereichsweise ein invertiertes bzw. komplementäres Abbild der Kontur des Gehäuses. Hier bildet die Zentrierkontur 112 Einführschrägen der Aussparung des Gehäuses zumindest teilweise ab.

In einem Ausführungsbeispiel weist der Kontaktstift 102 einen seitlich abgeflachten Kopfbereich 114 auf. Der Kopfbereich 114 ist damit ähnlich geformt, wie die Aussparung, in die der Kopfbereich 114 eintauchen soll. Die Zentrierhilfe 104 weist einen seitlich zum Kopfbereich 114 versetzten Zentrierbereich 116 auf. Damit kann die Zentrierhilfe 104 an einer neben der Aussparung angeordneten Kontur des Gehäuses zentrieren.

In einem Ausführungsbeispiel weist der Zentrierbereich 116 eine Nut 118 auf. Der Kopfbereich 114 ist zumindest teilweise in der Nut 118 angeordnet. Die Nut 118 führt den Kopfbereich 114 zumindest in einer Raumrichtung quer zur Nut 118. Hier ist der Kopfbereich 114 näherungsweise zur Hälfte in der Nut 118 angeordnet. Dabei ist eine schmale Seite des Kopfbereichs 114 am Grund der Nut 118 angeordnet. Die Nut 118 ist dabei mittig im Zentrierbereich 116 angeordnet. Der Kopfbereich 114 und der Zentrierbereich 116 sind also T-förmig zueinander ausgerichtet, wobei der Kopfbereich 114 den Stamm des T ausbildet und der Zentrierbereich 116 den Deckstrich des T ausbildet. Der Kopfbereich 114 ist dabei quer zu einem zu kontaktierenden Kontaktelement ausgerichtet und kann daher nicht in das Kontaktelement eindringen, sondern nur eindringungsfrei auf einer Oberfläche des Kontaktelements aufsetzen.

In einem Ausführungsbeispiel weist die Einzelkontaktierungseinrichtung 100 eine koaxial zur Zentrierhilfe 104 angeordneten Hülse 120 auf. Eine die Zentrierhilfe 104 abstützende Feder ist innerhalb der Hülse 120 angeordnet. Die Hülse 120 umschließt dabei einen als Hohlzylinder ausgeführten Schaft 122 der Zentrierhilfe 104. Ein Schaft des Kontaktstifts 102 ist innerhalb des Schafts 122 der Zentrierhilfe 104 angeordnet. Der Kopfbereich 114 ragt aus dem Schaft 122 heraus. Der Schaft des Kontaktstifts 102 ist dünner als der Kopfbereich 114. Eine Endfläche 124 des Schafts 122 liegt im ausgefederten Zustand an einer Anschlagfläche 126 des Kopfbereichs 114 an. Der Zentrierbereich 116 ist seitlich versetzt zum Schaft 122 angeordnet und verlängert die Zentrierhilfe 104 über die Stirnfläche 108 des Kopfbereichs 114 hinaus.

Fig. 2 zeigt eine räumliche Darstellung eines Steckverbinders 200 mit einer Einzelkontaktierungseinrichtung 100 gemäß einem Ausführungsbeispiel. Die Einzelkontaktierungseinrichtung 100 entspricht dabei im Wesentlichen der Einzelkontaktierungseinrichtung in Fig. 1. Die Einzelkontaktierungseinrichtung 100 ist hier über einer Aussparung 202 eines Gehäuses 204 des Steckverbinders 200 angeordnet.

Das Gehäuse 204 weist ein Raster gleichartiger Aussparungen 202 auf. Die Aussparungen 202 führen in das Gehäuse 204 hinein. Unterhalb der Aussparungen 202 sind im Gehäuse 204 Kontaktelemente des Steckverbinders 200 angeordnet. Die Einzelkontaktierungseinrichtung 100 ist dazu ausgebildet, eines der Kontaktelemente insbesondere eindringungsfrei elektrisch zu kontaktieren. Dazu wird der Kontaktstift 102 unter Verwendung der vorauseilenden Zentrierhilfe 104 an der Aussparung 202 ausgerichtet und taucht dann in ausgerichtetem Zustand in die Aussparung 202 ein, um auf dem Kontaktelement aufzusetzen.

In einem Ausführungsbeispiel weist die Aussparung 202 umlaufend Einführschrägen 206 auf. Die Zentrierhilfe 104 weist an ihrem vorauseilenden Ende eine zu den Einführschrägen 206 passende Zentrierkontur auf. Wenn die Einzelkontaktierungseinrichtung 100 einen Seitenversatz und/oder einen Winkelversatz zum Steckverbinder 200 aufweist, rutscht die vorauseilende Zentrierhilfe 104 durch die Zentrierkontur soweit auf den Einführschrägen 206 ab, bis die Zentrierhilfe 104 in der Aussparung 202 zentriert ist. Die Zentrierhilfe 104 zentriert sich dabei bevor der Kontaktstift 102 beginnt, in die Aussparung 202 einzutauchen. Dadurch kann der Kontaktstift 102 in die Aussparung eintauchen, ohne das Gehäuse 204 zu berühren.

In einem Ausführungsbeispiel ist die Aussparung 202 funktional zweigeteilt. Ein erster Teilbereich 208 ist dazu ausgebildet, ein Kontaktelement eines korrespondierenden Steckverbinders zu zentrieren und aufzunehmen, um eine sichere elektrische Verbindung zwischen den Kontaktelementen herzustellen. Ein zweiter Teilbereich 210 ist dazu ausgebildet, den Kontaktstift 102 bei der elektrischen Prüfung aufzunehmen. Damit der Kontaktstift 102 bei der Prüfung nicht in das Kontaktelement eindringen kann, ist der zweite Teilbereich 210 quer zu dem ersten Teilbereich 208 ausgerichtet. Die Aussparung 202 weist damit eine T-Form auf. Die Einführschrägen 206 sind dabei nur im ersten Teilbereich 208 ausgebildet. Im zweiten Teilbereich 210 weist die Aussparung 202 keine Einführschrägen auf. Der zweite Teilbereich 210 endet scharfkantig an einer Oberfläche des Gehäuses 204. Der zweite Teilbereich 210 kann als Prüfaussparung bezeichnet werden.

Die vorauseilende Zentrierhilfe 104 zentriert sich an dem ersten Teilbereich 208. Durch die Zentrierhilfe 104 wird der Kontaktstift 102 sicher an dem zweiten Teilbereich 210 ausgerichtet. Da die Zentrierhilfe 104 seitlich versetzt zu dem Kontaktstift 102 angeordnet ist, wird das Eintauchen in den zweiten Teilbereich 210 der Aussparung 102 nicht behindert.

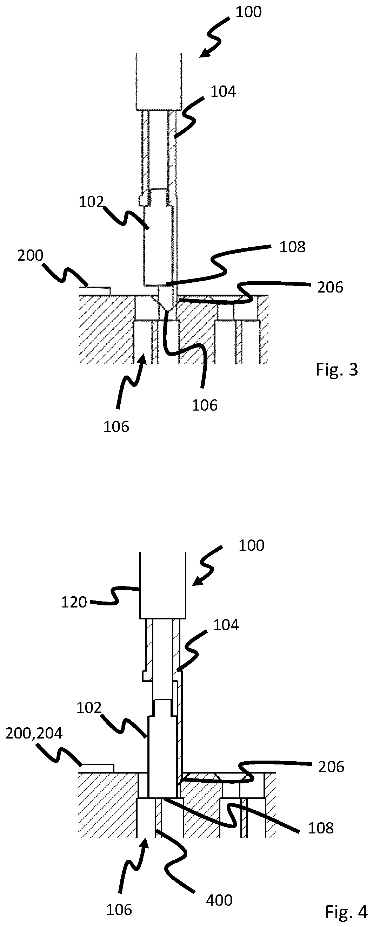

Die Fign. 3 und 4 zeigen Schnittansichten eines Steckverbinders 200 mit einer Einzelkontaktierungseinrichtung 100 gemäß einem Ausführungsbeispiel. Die Einzelkontaktierungseinrichtung 100 entspricht dabei im Wesentlichen der Einzelkontaktierungseinrichtung in Fig. 1. Der Steckverbinder 200 entspricht im Wesentlichen der Darstellung in Fig. 2.

In Fig. 3 ist das vorauseilende Ende 106 der Zentrierhilfe 104 in den Einführschrägen 206 der Aussparung 202 zentriert dargestellt. Der Zentriervorgang ist beendet, bevor der Kontaktstift 102 beginnt, in die Aussparung 202 einzutauchen. Hier ist der Zentriervorgang beendet, wenn die Stirnfläche 108 des Kontaktstifts 102 noch in einem Abstand über dem Steckverbinder 200 angeordnet ist.

In Fig. 4 ist der Kontaktstift 102 in die Aussparung 202 eingetaucht dargestellt. Die Stirnfläche 208 liegt auf dem Kontaktelement 400 auf und kontaktiert es elektrisch leitend aber eindringungsfrei. Das Kontaktelement 400 ist hier ein Lamellenkontakt. Damit der Kontaktstift 102 in das Gehäuse 204 eintauchen kann, bleibt die Zentrierhilfe 104 an den Einführschrägen 206 zentriert und federt koaxial zum Kontaktstift 102 in die Hülse 120 ein. Dadurch steht der Kontaktstift 102 effektiv über die Zentrierhilfe 104 über, solange der Kontaktstift 102 in die Aussparung 202 eingetaucht ist. Wenn der Kontaktstift 102 wieder von dem Kontaktelement 400 abgehoben wird, federt die Zentrierhilfe 104 wieder aus und hebt von dem Gehäuse 204 ab, nachdem der Kontaktstift 102 die Aussparung 202 bereits wieder verlassen hat.

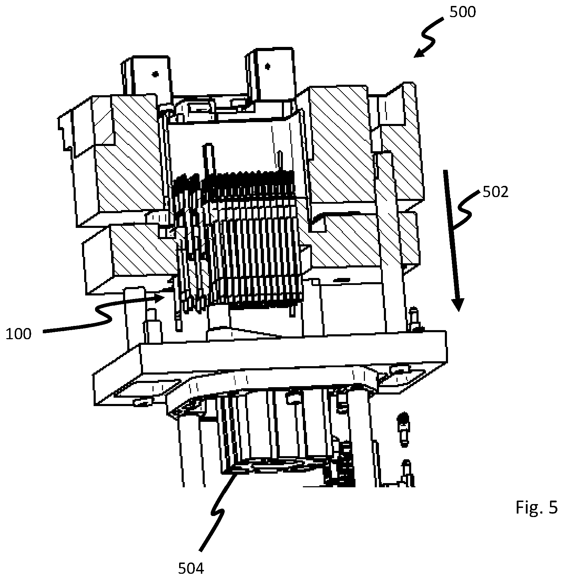

Fig. 5 zeigt eine räumliche Darstellung einer Prüfvorrichtung 500 gemäß einem Ausführungsbeispiel. Die Prüfvorrichtung 500 ist dazu ausgebildet, je einen Steckverbinder zu kontaktieren und so eine elektrische Prüfung des Steckverbinders zu ermöglichen. Die Prüfvorrichtung 500 weist eine Vielzahl von parallel in einer Steckrichtung 502 des Steckverbinders ausgerichteten Einzelkontaktierungseinrichtungen 100 gemäß dem hier vorgestellten Ansatz auf. Die Einzelkontaktierungseinrichtungen 100 sind an einem Raster von Kontaktelementen des Steckverbinders ausgerichtet. Zum Aufnehmen des Steckverbinders weist die Prüfvorrichtung 500 eine Aufnahme 504 auf. Die Aufnahme 504 ist in der Steckrichtung 502 relativ zu den Einzelkontaktierungseinrichtungen 100 automatisiert verfahrbar. Die Steckrichtung 502 stimmt dabei mit einer Aufsetzrichtung der Einzelkontaktierungseinrichtungen 100 überein.

Beim Schließen der Prüfvorrichtung 500 setzen zuerst die Zentrierhilfen der Einzelkontaktierungseinrichtungen 100 auf dem Steckverbinder auf und zentrieren sich an der Kontur des Steckverbinders. Durch die Zentrierhilfen sind die Kontaktstifte der Einzelkontaktierungseinrichtungen 100 an den Aussparungen des Steckverbinders ausgerichtet und können ohne Verkanten in die Aussparungen eintauchen, um die in den Aussparungen angeordneten Kontaktelemente des Steckverbinders elektrisch zu kontaktieren.

Mit anderen Worten werden verdrehgesicherte Federkontaktstifte mit gefederter Zentrierhilfe vorgestellt.

Bei herkömmlichen Federkontaktstiften kann es durch immer kleiner werdende Toleranzen zu einer fehlerhaften Kontaktierung der zu prüfenden Kontaktteile kommen. Derzeit wird ein Kontaktstift mit einer rechteckigen Form in der vorgeschriebenen Kontaktfläche verwendet. Durch das kleine Raster und die hohe Anzahl der Kontaktstifte sind sehr enge Toleranzen nötig, die in der Fertigung oft nur schwer eingehalten werden können (Abstandsmaß und Winkel). Zusätzlich ist eine bestimmte Kopfgeometrie zur Kontaktierung vorgegeben. Diese erlaubt es nicht, die Kontaktfläche mit Einführschrägen auszustatten, um einfacher in die Gehäusekammer zu rutschen.

Das Steckergehäuse hat nur für den Bereich eines eindringenden Kontaktteils eine Fase als Einführhilfe. Da eine eindringende Prüfung in den meisten Fällen untersagt ist und es zusätzlich noch Vorgaben für die Kopfform einer nicht eindringenden Prüfung gibt, weist das Gehäuse spezielle Prüföffnungen auf, welche jedoch nicht mit einer Fase als Einführhilfe ausgestattet sind.

Durch den hier vorgestellten Ansatz können Wackelkontakte an Teststationen verringert und so Prüfzeiten minimiert werden.

Bei dem hier vorgestellten Ansatz wird durch eine spezielle Kopfform mit einer gefederten Erweiterung (T-Form) des Kontaktstifts in Anlehnung an die Form der Gehäuseaussparung für die Kontaktteile eine bessere Zentrierung ermöglicht. Die gefederte Erweiterung sitzt auf der Gehäuseaussparung auf, zentriert durch die Formgebung den Kontaktstift und führt ihn parallel bis zum Auftreffen auf dem Anschlagteil. Die spezielle Form der Kontaktstifte erlaubt es, dass die Herstellervorgaben eingehalten werden. In Kombination mit einer verfahrbaren Ebene im Prüfadapter wird somit ein perfektes und gerades Einfädeln in die Gehäusekammer bis zum stirnseitigen Aufsitzen auf dem Anschlagteil sichergestellt.

Durch den hier vorgestellten Ansatz kann eine bessere Führung des Kontaktstiftes im Gehäuse und dadurch eine zuverlässige Kontaktierung des Steckers bei Prüfungen erreicht werden. Dazu wird der Kontaktstift um eine gefederte Zentrierhilfe erweitert, die die rechteckige Kopfform um eine beidseitige Ausprägung in Form einer T-Kontur ergänzt (Draufsicht). Dieses Zusatzbauteil kann je nach Bedarf an der Oberseite nur kurz angefast sein, oder eine konkrete Schräge aufweisen. Diese gefederte Zentrierhilfe ist von der Oberkante des Standardkontaktstift (um 1,3) mm vorauseilend, damit der Kontaktstift schon zentriert ist bevor die Prüffläche in das Gehäuse eintaucht.

Da es sich bei der vorhergehend detailliert beschriebenen Vorrichtungen und Verfahren um Ausführungsbeispiele handelt, können sie in üblicher Weise vom Fachmann in einem weiten Umfang modifiziert werden, ohne den Bereich der Erfindung zu verlassen. Insbesondere sind die mechanischen Anordnungen und die Größenverhältnisse der einzelnen Elemente zueinander lediglich beispielhaft gewählt.

### BEZUGSZEICHENLISTE

- 100: Einzelkontaktierungseinrichtung
- 102: Kontaktstift
- 104: Zentrierhilfe
- 106: vorauseilendes Ende
- 108: Stirnfläche
- 110: Zentrierschräge
- 112: Zentrierkontur
- 114: Kopfbereich
- 116: Zentrierbereich
- 118: Nut
- 120: Hülse
- 122: Schaft
- 124: Endfläche
- 126: Anschlagfläche

- 200: Steckverbinder
- 202: Aussparung
- 204: Gehäuse
- 206: Einführschräge
- 208: erster Teilbereich
- 210: zweiter Teilbereich

- 400: Kontaktelement

- 500: Prüfvorrichtung
- 502: Steckrichtung
- 504: Aufnahme

## Patentansprüche

1. Einzelkontaktierungseinrichtung (100) für eine Prüfvorrichtung (500) zum Durchgangsprüfen eines Steckverbinders (200), wobei die Einzelkontaktierungseinrichtung (100) einen Kontaktstift (102) zum Aufsetzen auf ein zu kontaktierendes Kontaktelement (400) des Steckverbinders (200) und eine vorauseilende Zentrierhilfe (104) für den Kontaktstift (102) aufweist, wobei der Kontaktstift (102) elektrisch leitend und in einer Aufsetzrichtung federgelagert ist und die Zentrierhilfe (104) koaxial zum Kontaktstift (102) beweglich federgelagert ist, wobei der Kontaktstift (102) einen abgeflachten Kopfbereich (114) aufweist,
**dadurch gekennzeichnet, dass**
die Zentrierhilfe (104) einen seitlich zum Kopfbereich (114) versetzten Zentrierbereich (116) aufweist, wobei der Zentrierbereich (116) an dem Kopfbereich (114) anliegt und das vorauseilende Ende (106) ausbildet, und
wobei der Kopfbereich (114) zumindest anteilig in einer Nut (118) des Zentrierbereichs (116) angeordnet ist.

2. Einzelkontaktierungseinrichtung (100) gemäß Anspruch 1, bei der ein vorauseilendes Ende (106) der Zentrierhilfe (104) eine Zentrierschräge (110) aufweist.

3. Einzelkontaktierungseinrichtung (100) gemäß einem der vorhergehenden Ansprüche, bei der die Zentrierhilfe (104) an einem vorauseilenden Ende (106) eine Zentrierkontur (112) aufweist, wobei die Zentrierkontur (112) zumindest bereichsweise komplementär zu einer Steckkontur des Steckverbinders (200) ausgebildet ist.

4. Einzelkontaktierungseinrichtung (100) gemäß einem der vorhergehenden Ansprüche, mit einer koaxial zum Kontaktstift (102) und/oder der Zentrierhilfe (104) angeordneten Hülse (120), wobei eine die Zentrierhilfe (104) abstützende Feder innerhalb der Hülse (120) angeordnet ist.

5. Einzelkontaktierungseinrichtung (100) gemäß einem der vorhergehenden Ansprüche, bei der die Zentrierhilfe (104) in einer ausgefederten Position an einer Anschlagfläche (126) des Kopfbereichs (114) anliegt.

6. Einzelkontaktierungseinrichtung (100) gemäß einem der einem der vorhergehenden Ansprüche, bei der der Kopfbereich (114) und der Zentrierbereich (116) T-förmig zueinander ausgerichtet sind.

7. Einzelkontaktierungseinrichtung (100) gemäß einem der vorhergehenden Ansprüche, bei der die Zentrierhilfe (104) einen hohlzylindrischen Schaft (122) aufweist und der Kontaktstift (102) einen zylindrischen Schaft aufweist, der in dem hohlzylindrischen Schaft (122) angeordnet ist.

8. Prüfvorrichtung (500) zum elektrischen Prüfen eines Steckverbinders (200), wobei die Prüfvorrichtung (500) zumindest eine Einzelkontaktierungseinrichtung (100) gemäß einem der vorhergehenden Ansprüche aufweist.

## Claims

1. Individually contacting apparatus (100) for a testing device (500) for continuity testing of a plug connector (200), wherein the individually contacting apparatus (100) comprises a contact pin (102) for placing onto a contact element (400) of the plug connector (200) to be contacted, and a leading centering aid (104) for the contact pin (102), wherein the contact pin (102) is electrically conductive and resiliently mounted in a placement direction, and the centering aid (104) is resiliently mounted so as to be movable coaxially with respect to the contact pin (102), wherein the contact pin (102) has a flattened head portion (114), **characterized in that** the centering aid (104) has a centering portion (116) laterally offset relative to the head portion (114), wherein the centering portion (116) bears against the head portion (114) and forms the leading end (106), and wherein the head portion (114) is arranged at least partially in a groove (118) of the centering portion (116).

2. The individually contacting apparatus (100) according to claim 1, wherein the leading end (106) of the centering aid (104) has a centering chamfer (110).

3. The individually contacting apparatus (100) according to any one of the preceding claims, wherein the centering aid (104) has a centering contour (112) at the leading end (106), the centering contour (112) being formed at least in sections so as to be complementary to a plug contour of the plug connector (200).

4. The individually contacting apparatus (100) according to any one of the preceding claims, comprising a sleeve (120) arranged coaxially with the contact pin (102) and/or the centering aid (104), wherein a spring supporting the centering aid (104) is arranged within the sleeve (120).

5. The individually contacting apparatus (100) according to any one of the preceding claims, wherein the centering aid (104), in an relaxed position, bears against a stop surface (126) of the head portion (114).

6. The individually contacting apparatus (100) according to any one of the preceding claims, wherein the head portion (114) and the centering portion (116) are oriented T-shaped with respect to one another.

7. The individually contacting apparatus (100) according to any one of the preceding claims, wherein the centering aid (104) has a hollow-cylindrical shaft (122) and the contact pin (102) has a cylindrical shaft which is arranged within the hollow-cylindrical shaft (122).

8. Testing device (500) for electrically testing a plug connector (200), wherein the testing device (500) comprises at least one individually contacting apparatus (100) according to any one of the preceding claims.

## Revendications

1. Appareil de mise en contact individuel (100) destiné à un dispositif de test (500) pour le contrôle de continuité d'un connecteur enfichable (200), le appareil de mise en contact individuel (100) comprenant un plot de contact (102) destiné à être appliqué sur un élément de contact (400) du connecteur enfichable (200) à contacter, et une aide de centrage avancée (104) pour le plot de contact (102), le plot de contact (102) étant électriquement conducteur et monté de manière élastique dans une direction d'appui, et l'aide de centrage (104) étant montée de manière élastique et mobile coaxialement par rapport au plot de contact (102), et le plot de contact (102) présente une portion de tête aplatie (114), **caractérisé en ce que** l'aide de centrage (104) présente une portion de centrage (116) décalée latéralement par rapport à la portion de tête (114), la portion de centrage (116) venant en appui contre la portion de tête (114) et formant une extrémité avancée (106), et la portion de tête (114) est disposée au moins partiellement dans une rainure (118) de la portion de centrage (116).

2. Appareil de mise en contact individuel (100) selon la revendication 1, dans lequel l'extrémité avancée (106) de l'aide de centrage (104) présente un chanfrein de centrage (110).

3. Appareil de mise en contact individuel (100) selon l'une quelconque des revendications précédentes, dans lequel l'aide de centrage (104) présente, à l'extrémité avancée (106), un profil de centrage (112), ledit profil de centrage (112) étant formé au moins partiellement de manière complémentaire à un profil d'enfichage du connecteur enfichable (200).

4. Appareil de mise en contact individuel (100) selon l'une quelconque des revendications précédentes, comprenant une douille (120) disposée coaxialement par rapport au plot de contact (102) et/ou à l'aide de centrage (104), un ressort destiné à supporter l'aide de centrage (104) étant disposé à l'intérieur de la douille (120).

5. Appareil de mise en contact individuel (100) selon l'une quelconque des revendications précédentes, dans lequel l'aide de centrage (104), dans une position sortie élastiquement, vient en appui contre une surface de butée (126) de la portion de tête (114).

6. Appareil de mise en contact individuel (100) selon l'une quelconque des revendications précédentes, dans lequel la portion de tête (114) et la portion de centrage (116) sont disposées en configuration en T l'une par rapport à l'autre.

7. Appareil de mise en contact individuel (100) selon l'une quelconque des revendications précédentes, dans lequel l'aide de centrage (104) présente un arbre tubulaire cylindrique (122) et le plot de contact (102) présente un arbre cylindrique disposé à l'intérieur de l'arbre tubulaire cylindrique (122).

8. Dispositif de test (500) destiné au contrôle électrique d'un connecteur enfichable (200), le dispositif de test (500) comprenant au moins un appareil de mise en contact individuel (100) selon l'une quelconque des revendications précédentes.
